# EUROPÄISCHE PATENTSCHRIFT

(11) **EP 0 490 903 B1**
(45) Veröffentlichungstag und Bekanntmachung des Hinweises auf die Patenterteilung: **21.04.1993**
(21) Anmeldenummer: 90911754.1
(22) Anmeldetag: 07.08.1990
(51) Int. Cl.: H01P 1/203, H03H 7/01

(54) **Mikrowellen filter**
Microwave filter
Filtre à micro-ondes

(30) Priorität: 04.09.1989 DE 3929362
(43) Veröffentlichungstag der Anmeldung: 24.06.1992
(73) Patentinhaber: FRAUNHOFER-GESELLSCHAFT ZUR FÖRDERUNG DER ANGEWANDTEN FORSCHUNG E.V., 80636 München (DE)
(72) Erfinder: WALLRAPP, Ludwig, D-8520 Erlangen (DE); SEITZER, Dieter, D-8520 Erlangen (DE)
(74) Vertreter: Schoppe, Fritz, Dipl.-Ing.
(86) Internationale Anmeldenummer: DE9000608
(87) Internationale Veröffentlichungsnummer: WO9103845

(56) Entgegenhaltungen:
- DE-A- 2 112 040
- GB-A- 2 184 909
- US-A- 3 947 934
- US-A- 4 758 805
- PATENT ABSTRACTS OF JAPAN, vol. 10, No. 27, (E-378) (2084) 04 Februa -ry 1986 & JP-A-60 185402
- FREQUENZ. vol. 30, no. 8, August 1976, Berlin de pages 209-220; R. BRIECHLE: "Kammleitungsfilter aus gekoppelten Mikrostreifenleitungen" see page 215, right hand column, lines 4-12, figure 6

## Beschreibung

Die vorliegende Erfindung betrifft ein Mikrowellenfilter nach dem Oberbegriff des Patentanspruchs 1.

Es ist allgemein bekannt, bei Hochpaßfiltern, Tiefpaßfiltern, Bandpaßfiltern oder sonstigen Spezialfiltern die induktiven Elemente in Streifenleitungstechnik auszuführen. In Streifenleitungstechnik ausgeführte induktive Elemente sind gegenüber herkömmlichen induktiven Elementen, die beispielsweise als gewickelte Spulen ausgeführt sind, in der Regel einfacher und kostengünstiger auszuführen, so daß man bemüht ist, induktive Elemente durch Streifenleitungen zu ersetzen, soweit dies aufgrund des Frequenzbereiches und der geforderten Durchlaßkurve des Filters möglich ist.

Es ist gleichfalls bekannt, derartige, in Streifenleitungstechnik ausgeführte induktive Elemente als planare, im wesentlichen spiralförmig verlaufende Streifenleitung mit jeweils abschnittsweise geraden Streifenleitungsstücken auszuführen. Eine derartige spiralförmige Streifenleitung hat als induktives Element zwar gegenüber einer gerade verlaufenden Streifenleitung den erheblichen Vorteil, daß sie auf einer vergleichsweise geringen Fläche realisiert werden kann. Jedoch benötigt man zum Entwurf eines derartigen induktiven Elementes ein spezielles Computerprogramm, das ausschließlich für die Dimensionierung bzw. den Entwurf eines derartigen induktiven Elementes verwendbar ist.

Gleichfalls ist es denkbar, induktive Elemente in Streifenleitungstechnik beispielsweise durch mäanderförmige Strukturen zu realisieren. Die elektrischen Eigenschaften einer derartigen mäanderförmigen Streifenleitungsstruktur lassen sich jedoch nur noch mit äußerst umfangreichen feldtheoretischen Analyseprogrammen, wie beispielsweise dem Feldtheorie-Programm "Linmic plus" simulieren. Derartige Programme, die auch nur auf wenigen Computern lauffähig sind, stehen dem Entwicklungsingenieur üblicherweise nicht zur Verfügung.

Bei einem Tiefpaßfilter der oben genannten Art, wie es in der DE-AS 19 26 501 beschrieben ist, sind die kapazitiven Elemente als plattenförmige, metallische Beläge ausgebildet, die beidseitig auf einem zweischichtigen Dielektrikum mit dazwischenliegender Massebeschichtung angeordnet sind. Die kapazitiven Beläge weisen einen derart niedrigen gegenseitigen Abstand auf, daß zwischen diesen eine kapazitive Kopplung auftritt. Zwischen den kapazitiven Elementen liegen die in Streifenleitungstechnik ausgeführten induktiven Elemente, die aus den im wesentlichen U-förmigen Streifenleitungsabschnitten gebildet sind. Bei vorgegebenem Flächenbedarf dieses bekannten Filters eignet sich dieses aufgrund der niedrigen Kapazitätswerte seiner kapazitiven Elemente und der niedrigen Induktivitätswerte seiner induktiven Elemente nur für die Realisierung von Filtern mit hohen Grenzfrequenzen.

Mit einfachen, dem Fachmann überlicherweise zur Verfügung stehenden Mikrowellen-Simulationsprogrammen kann dieses Filter nicht berechnet werden.

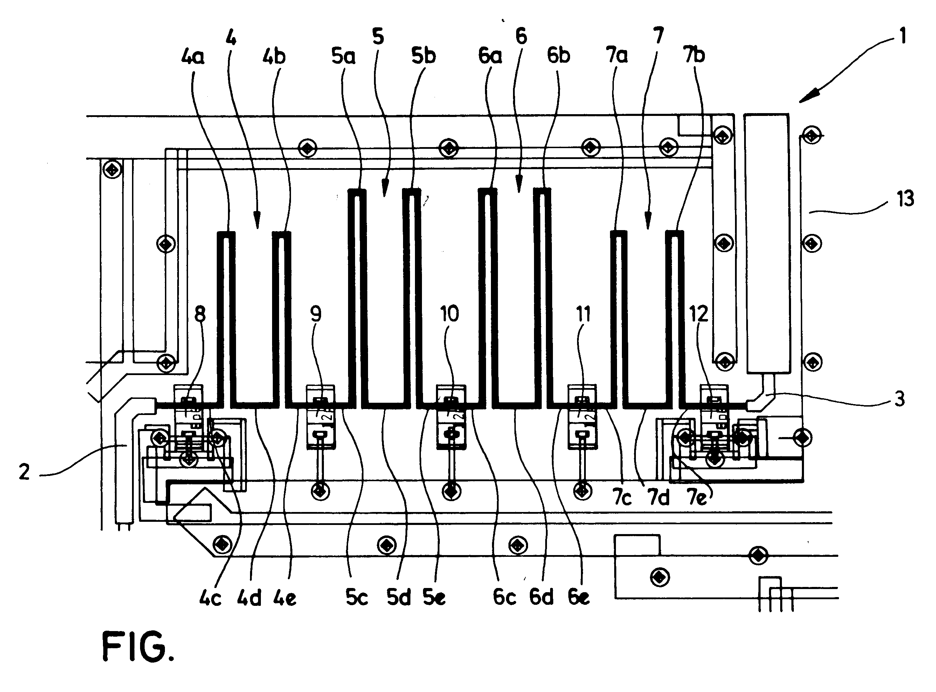

Ein vom Aufbau her ähnliches Filter ist aus der Fig. 10 der GB-PS 13 40 168 bekannt. Dieses weist drei parallele Leitungskapazitäten auf, die mit geringem gegenseitigem Abstand für eine gegenseitige kapazitive Kopplung angeordnet sind. Zwischen parallelen Leitungskapazitäten liegen Impedanzschleifen, von denen jede einen im wesentlichen U-förmigen Streifenleitungsabschnitt umfaßt. Zum gegenseitigen Abstand der beiden Leitungen des Streifenleitungsabschnittes wird in der Entgegenhaltung lediglich ausgeführt, daß dieser nicht mit dem Abstand zwischen den Leitungskapazitäten übereinstimmen müsse. Bei einem Ausführungsbeispiel gemäß Fig. 7 dieser GB-PS 13 40 168 stimmt der Abstand der beiden Schenkel eines Streifenleitungsabschnittes mit dem gegenseitigen Abstand zweier Streifenleitungsabschnitte zweier benachbarter induktiver Elemente überein.

Zwar können die Eigenschaften dieses Filters aufgrund der in der Entgegenhaltung angegebenen Näherungsformeln ungefähr vorherbestimmt werden. Es ist jedoch nicht möglich, dieses Filter mittels eines einfachen Mikrowellen-Simulationsprogrammes zu simulieren und zu dimensionieren.

Die DE-OS 36 42 934 zeigt ein Mikrowellenfilter, dessen induktives Element als Streifenleitungsmäander ausgeführt ist, wobei die hintereinander geschalteten, im wesentlichen U-förmigen Abschnitte des Mäanders einen jeweils gleichmäßigen gegenseitigen Abstand haben. Dieses Filter hat Chip-Kondensatoren. Der Einfluß parasitärer serieller Induktivitäten der Kondensatoren wird bei der Auslegung dieses bekannten Filters offenbar vernachlässigt.

Aus der Veröffentlichung SELLHORN, E.: "Berechnung mäanderförmiger Induktivitäten in gedruckten Schaltungen". In: "radio und fernsehen", 16 (1967) Heft 23, S. 725, 726 ist es lediglich bekannt, mäanderförmige Induktivitäten bei Tiefpaßfiltern einzusetzen, bei denen der Abstand der Schenkel eines U-förmigen Streifenleitungsabschnittes ebenso groß ist, wie derjenige von einem Streifenleitungsabschnitt zum nächsten. Derartige Strukturen sind mit einfachen Mikrowellen-Simulationsprogrammen nicht berechenbar.

Aus der US-A-3947934 ist eine abstimmbare Filterschaltung bekannt, die eine Kapazität beispielsweise in Form eines Chip-Kondesators, eine feste Induktivität in Form eines Spulenkörpers sowie trimmbare Induktivitäten in Form von Streifenleitungen aufweist. Die trimmbare Streifenleitungsinduktivität wird dadurch in ihrem Induktivitätswert eingestellt, indem ein Einschnitt in einem flächenartigen Streifenleitungskörper zum Erzeugen von U-förmigen Streifenleitungsabschnitten mit geeigneter Länge durch Entfernen von Streifenleitungsmaterial erzeugt wird. Das bekannte Filter ist nicht mit Mikrowellen-Simulationsprogrammen berechenbar.

Aus der US-A-4758805 ist eine Hochfrequenzfilterstruktur zum Schutz elektrischer Instrumente gegen hochfrequente Wellen bekannt, die in Streifenleitungstechnik ausgeführte induktive Elemente in Form eines U-förmigen Streifenleitungsabschnittes aufweist, die mit konkreten Kondensatorelementen verbunden sind. Die U-förmigen Streifenleitungsabschnitte erstrecken sich bei einer Ausführungsform um die Peripherie eines senkrecht zum Isolatorkörper der Schaltung stehenden weiteren Isolatorkörpers. Irgendwelche Hinweise auf eine solche Auslegung, die eine Berechnung dieses Filters mittels eines Mikrowellen-Simulationsprogrammes erlaubt, sind dieser Schrift nicht zu entnehmen.

Aus der GB-A-2184909 ist eine Filterstruktur für ein Bandpaß-Filter bekannt, welches in Streifenleitungstechnik ausgeführte, U-förmige Streifenleitungsabschnitte aufweisende induktive Elemente sowie als konkrete Kondensatoren ausgebildete kapazitive Elemente aufweist. Die einzelnen Streifenleitungsabschnitte sind mäanderförmig mit gleichmäßigen gegenseitigen Abständen ausgeführt. Mittels einfacher Mikrowellen-Simulationsprogramme können derartige Filter nicht berechnet werden.

Aus Patent Abstracts of Japan, Band 10, Nr. 27 (E 378) (2084) sowie aus der JP-A-60185402 ist eine Mikrowellenfilterstruktur in Streifenleitungstechnik bekannt, die eine eingangsseitige und eine ausgangsseitige gerade Einkoppel- bzw . Auskoppel-Leitung sowie eine Mehrzahl von gegenseitig beabstandeten, nicht miteinander leitend verbundenen U-förmigen Resonatoren aufweist, wobei die Einkoppelleitung bzw. Auskoppelleitung und der hierzu benachbarte jeweilige Resonator bzw. die Resonatoren untereinander miteinander kapazitiv gekoppelt sind, indem sie mit nur geringen Abständen voneinander angeordnet sind.

Aus der Fachzeitschrift "Frequenz" Band 30, Nr. 8, August 1976, Seiten 209 - 220 sind verschiedene Kammleitungsfilter aus gekoppelten Mikrostreifenleitungen bekannt. Die Kammleitungsfilter umfassen jeweils parallel gleichmäßig beabstandet zueinander angeordnete Streifenleitungselemente.

Aus der DE-A-2112040 sind verschiedene Netzwerke aus konzentrierten Schaltungselementen oder Streifenleitungselementen bekannt. Teilweise sind die Netzwerke als Tiefpaßfilterstrukturen ausgeführt. Bei diesen Filterstrukturen sind verkürzte induktive Elemente in Streifenleitungstechnik durch Parallelschalten der Streifenleitungsinduktivitäten mit Widerstandselementen realisiert.

Ausgehend von diesem Stand der Technik, liegt der vorliegenden Erfindung die Aufgabe zugrunde, ein Mikrowellenfilter der eingangs genannten Art zu schaffen, welches trotz niedrigem Raumbedarf bei gegebener Grenzfrequenz mit einem einfachen Mikrowellen-Simulationsprogramm berechnet werden kann.

Diese Aufgabe wird durch ein Mikrowellenfilter gemäß Patentanspruch 1 gelöst.

In völliger Abkehr vom Stand der Technik lehrt die Erfindung, daß einerseits bei Einsatz von Chip-Kondensatoren deren serielle parasitäre Induktivität bekannt ist und daß ausgehend von dem Wert der bekannten seriellen Induktivität eine Dimensionierung des induktiven Elementes mit einem einfachen Mikrowellen-Simulationsprogramm möglich ist, da hierbei einerseits die parasitäre Induktivität des Kondensators berücksichtigbar ist und andererseits das induktive Element derart aufgeteilt ist, daß es wenigstens zwei U-förmige Streifenleitungsabschnitte umfaßt, die nur eine nennenswerte Kopplung zwischen den beiden Schenkeln, nicht jedoch eine zu berücksichtigende Kopplung zum benachbarten Streifenleitungsabschnitt haben. Damit wendet sich die Erfindung vom Stand der Technik ab, der immer dann, wenn ein induktives Element aufgrund der Flächenvorgaben nicht mehr als einzelner U-förmiger Streifenleitungsabschnitt realisierbar ist, dessen Realisierung durch ein Mäander oder eine Spiralform gelehrt hat.

Erst durch diese Lehre der Erfindung ist es möglich, mit den begrenzten Möglichkeiten einfacher Mikrowellen-Simulationsprogramme, das erfindungsgemäße Filter bei niedrigem Raumbedarf auch im Falle von niedrigen Grenzfrequenzen hochgenau zu dimensionieren.

Vorteilhafte Weiterbildungen sind in den Unteransprüchen angegeben.

Nachfolgend wird unter Bezugnahme auf die einzige Figur eine bevorzugte Ausführungsform eines erfindungsgemäßen Filters näher erläutert.

Es zeigt: die einzige Figur eine Draufsicht auf eine Ausführungsform eines Tiefpaßfilters gemäß der Erfindung.

Wie der Figur zu entnehmen ist, umfaßt das Tiefpaßfilter, das in seiner Gesamtheit mit den Bezugszeichen 1 bezeichnet ist, zwischen einem Eingangsanschluß 2 und einem Ausgangsanschluß 3 ein erstes, zweites, drittes und viertes induktives Element 4,5,6,7, die jeweils in einem ersten, zweiten, dritten und vierten Längszweig des Tiefpaßfilters angeordnet sind. Ferner umfaßt der Tiefpaßfilter 1 einen ersten, zweiten, dritten, vierten und fünften Chip-Kondensator 8,9,10, 11,12, der jeweils mit seinem Chip-seitigen Anschluß mit dem Eingangsanschluß 2, dem Knoten zwischen zwei aufeinanderfolgenden induktiven Elementen 4,5,6,7 bzw. dem Ausgangsanschluß 3 verbunden ist, und der mit seinem Leitungsanschluß jeweils mit einer Masseleitung 13 in Verbindung steht.

Die Struktur derartiger Chip-Kondensatoren 8 bis 12 ist für die Zwecke der vorliegenden Erfindung von untergeordneter Bedeutung, solange die Kondensatoren 8 bis 12 über eine bekannte oder bestimmbare serielle parasitäre Induktivität verfügen, so daß diese bei dem Entwurf der einzelnen induktiven Elemente 4 bis 7 berücksichtigt werden kann.

Jedes induktive Element 4 bis 7 umfaßt zwei U-förmige Streifenleitungsabschnitte 4a, 4b, 5a, 5b, 6a, 6b, 7a, 7b sowie jeweils einen ersten Verbindungsstreifenleiter 4c, 5c, 6c, 7c zwischen dem Eingangsknoten des induktiven Elementes 4,5,6,7 und dem ersten Streifenleitungsabschnitt 4a, 5a, 6a, 7a, einen zweiten Verbindungsstreifenleiter 4d, 5d, 6d, 7d, der die beiden Streifenleitungsabschnitte 4a,b; 5a,b; 6a,b; 7a,b miteinander verbindet, und einen dritten Verbindungsstreifenleiter 4e, 5e, 6e, 7e, der jeweils zwischen dem zweiten Streifenleitungsabschnitt 4b, 5b, 6b, 7b und dem Ausgangsknoten des betreffenden induktiven Elementes 4,5,6,7 liegt.

Bei dem gezeigten Ausführungsbeispiel weisen die parallelen Schenkel der Streifenleitungsabschnitte 4a, 4b, 5a, 5b, 6a, 6b, 7a, 7b einen gegenseitigen Abstand von etwa 1,5 mm auf, während der gegenseitige Abstand zweier benachbarter U-förmiger Streifenleitungsabschnitte 4a, 4b, 5a, 5b, 6a, 6b, 7a, 7b bei etwa 9 bzw. 14 mm liegt. In jedem Fall muß die Kopplung zwischen den parallelen Schenkeln der U-förmigen Streifenleitungsabschnitte 4a, 4b, 5a, 5b, 6a, 6b, 7a, 7b durch einen entsprechend geringen Abstand zwischen den Schenkeln so stark sein, daß die gegenseitige Kopplung zwischen den Schenkeln benachbarter U-förmiger Streifenleitungsabschnitte hiergegen vernachlässigbar klein ist. In diesem Fall kann das Verhalten des induktiven Elementes mit einem einfachen, lediglich mit Näherungsformeln arbeitenden Mikrowellen-Simulationsprogramm für zweifach gekoppelte Leitungen berechnet werden, so daß es unnötig ist, für die Simulation des Filters komplexe Programme einzusetzen, mit denen die feldtheoretische Berechnung durchgeführt werden kann.

## Patentansprüche

1. Ein Mikrowellenfilter mit einer LC-Kombination
aus einem als Chip-Kondensator (8, 9, 10, 11, 12) ausgeführten kapazitiven Element und
einem in Streifenleitungstechnik ausgeführten induktiven Element (4, 5, 6, 7), das wenigstens zwei im wesentlichen U-förmige Streifenleitungsabschnitte (4a, 4b, 5a, 5b, 6a, 6b, 7a, 7b) aufweist, deren parallele Schenkel mit einem derart geringen Abstand zueinander angeordnet sind, daß diese paarweise gekoppelte Leitungen bilden,
dadurch gekennzeichnet,
daß die U-förmigen Streifenleitungsabschnitte (4a, 4b, 5a, 5b, 6a, 6b, 7a, 7b) voneinander einen derart weiten Abstand einhalten, daß die Kopplung zwischen diesen Streifenleitungsabschnitten klein gegenüber der gegenseitigen Kopplung zwischen den Schenkeln eines Streifenleitungsabschnittes ist, und
daß das Mikrowellenfilter wenigstens zwei solche LC-Kombinationen aufweist.

2. Filter nach Anspruch 1,
bei dem die Länge der Streifenleitung, die das induktive Element (4, 5, 6, 7) bildet, viel kleiner als ein Viertel der Wellenlänge bei der Grenzfrequenz des Filters ist.

3. Filter nach Anspruch 2,
bei dem die Länge der Streifenleitung, die das induktive Element (4, 5, 6, 7) bildet, kleiner als ein Zwölftel der Wellenlänge bei der Grenzfrequenz des Filters ist.

## Claims

1. A microwave filter including an LC combination, comprising
a capacitive element designed as a chip capacitor (8, 9, 10, 11, 12) and
a stripline-type inductive element (4, 5, 6, 7) having at least two essentially U-shaped stripline sect ions (4a, 4b, 5a, 5b, 6a, 6b, 7a, 7b) whose parallel legs are arranged to be so close together that they define lines which are coupled in pairs,
**characterized in**
that said U-shaped stripline sections (4a, 4b, 5a, 5b, 6a, 6b, 7a, 7b) are spaced apart at a distance from one another, which is so wide that the coupling between these stripline sections is small in comparison with the mutual coupling between the legs of one stripline section, and
that the microwave filter includes at least two such LC combinations.

2. A filter according to claim 1,
wherein the length of the stripline defining the inductive element (4, 5, 6, 7) is much smaller than one quarter of the wavelength at the limit frequency of the filter.

3. A filter according to claim 2,
wherein the length of the stripline defining the inductive element (4, 5, 6, 7) is smaller than one twelfth of the wavelength at the limit frequency of the filter.

## Revendications

1. Un filtre à micro-ondes avec une combinaison LC
d'un élément capacitif réalisé sous forme d'un condensateur à chip (8, 9, 10, 11, 12) et
un élément inductif (4, 5, 6, 7), réalisé selon la technique de ligne à bande, qui présente au moins deux segments de ligne à bande (4a, 4b, 5a, 5b, 6a, 6b, 7a, 7b) sensiblement en forme de "U" dont les branches parallèles sont disposées avec une distance aussi faible entre elles qu'elles forment des lignes couplées par paire, caractérisé en ce
que les segments de ligne à bande (4a, 4b, 5a, 5b, 6a, 6b, 7a, 7b) en forme de "U" maintiennent entre eux une distance telle que le couplage entre ces segments de ligne à bande est petit par rapport au couplage entre elles des branches d'un segment de ligne à bande, et
que le filtre à micro-ondes présente au moins deux de ces combinaisons LC.

2. Filtre suivant la revendication 1, dans lequel la longueur de la ligne à bande qui constitue l'élément inductif (4, 5, 6, 7) est beaucoup plus petite qu'un quart de la longueur d'onde à la fréquence limite du filtre.

3. Filtre suivant la revendication 2, dans lequel la longueur de la ligne à bande qui constitue l'élément inductif (4, 5, 6, 7) est plus petite qu'un douzième de la longueur d'onde à la fréquence limite du filtre.
